# DEMANDE DE BREVET EUROPEEN

(11) **EP 4 577 029 A1**
(43) Date de publication de la demande: **25.06.2025**
(21) Numéro de dépôt: 24220132.5
(22) Date de dépôt: 16.12.2024
(51) Int. Cl.: H10N 70/20

(54) **PROCÉDÉ DE FABRICATION D'UN CELLULE MÉMOIRE RÉSISTIVE DE TYPE OXRAM ET CELLULE MÉMOIRE DE TYPE OXRAM ASSOCIÉE**

(30) Priorité: 18.12.2023 FR 2314400
(71) Demandeur: Commissariat à l'Energie Atomique et aux Energies Alternatives, 75015 Paris (FR); Weebit Nano Ltd, 4527713 Hod-HaSharon (IL)
(72) Inventeur: MOLAS, Gabriel, 38040 GRENOBLE CEDEX 09 (FR); VERDY, Anthonin, 38040 GRENOBLE CEDEX 09 (FR); DORY, Jean-Baptiste, 38054 GRENOBLE CEDEX 09 (FR); NODIN, Jean-François, 38054 GRENOBLE CEDEX 09 (FR)
(74) Mandataire: Cabinet Camus Lebkiri

(57) **Abrégé**

L'invention concerne un procédé de fabrication d'une cellule mémoire résistive OxRAM, comprenant les étapes suivantes :
- formation d'une électrode inférieure en TiN,
- première implantation d'atomes de Si dans l'électrode inférieure avec une première dose d'implantation et une première tension d'accélération d'implantation, ladite première dose d'implantation étant strictement positive et strictement inférieure à 0,7.10¹⁴ cm⁻²,
- deuxième implantation d'atomes de Si dans l'électrode inférieure avec une deuxième dose d'implantation et une deuxième tension d'accélération d'implantation strictement supérieure à la première tension d'accélération d'implantation, ladite deuxième dose d'implantation étant strictement positive et strictement inférieure à 0,6.10¹⁴ cm⁻²,
les première et deuxième tensions d'accélération étant choisies pour avoir un profil d'implantation suite à la première et deuxième implantation présentant une concentration maximale de Si à une profondeur comprise entre 1 et 3 nm à partir de la surface supérieure de l'électrode inférieure,
- dépôt d'une couche active sur l'électrode inférieure implantée,
- dépôt d'une électrode supérieure sur la couche active.

## Description

### DOMAINE TECHNIQUE

La présente invention concerne de manière générale le domaine de la micro-électronique. Elle concerne plus particulièrement le domaine des mémoires résistives non volatiles de type filamentaire.

En particulier, la présente invention concerne un procédé de fabrication d'une cellule mémoire résistive de type OxRAM. Elle concerne également une telle cellule mémoire résistive de type OxRAM obtenue par le procédé de fabrication.

### ÉTAT DE LA TECHNIQUE

Les mémoires résistives, en particulier les mémoires résistives à base d'oxyde (ou OxRAM, pour « Oxide-based *Random Access Memories* » selon l'acronyme d'origine anglo-saxonne couramment utilisé), sont des mémoires nonvolatiles ayant pour but de remplacer les mémoires de type Flash. En plus d'une forte densité d'intégration, elles présentent une vitesse de fonctionnement élevée et une bonne compatibilité avec les procédés de fabrication utilisés actuellement dans l'industrie microélectronique, en particulier avec le procédé de fin de ligne (BEOL, pour « *Back-End Of Line* » selon l'acronyme d'origine anglo-saxonne couramment utilisé) de la technologie CMOS (pour « *Complementary Métal Oxide Semi-conductor* » selon l'acronyme d'origine anglo-saxonne couramment utilisé).

Les mémoires résistives OxRAM comprennent une multitude de cellules mémoire, appelées également points mémoire. Chaque cellule mémoire OxRAM est constituée d'une capacité M-I-M (Métal-Isolant-Métal) comprenant un matériau actif de résistance électrique variable, en général un oxyde de métal de transition (ex. HfO₂, Ta₂O₅, TiO₂...), disposé entre deux électrodes métalliques. La cellule mémoire commute de manière réversible entre deux états de résistance, qui correspondent à des valeurs logiques « 0 » et « 1 » utilisées pour coder un bit d'information. Dans certains cas, plus de deux états de résistance peuvent être générés, ce qui permet de stocker plusieurs bits d'information dans une même cellule mémoire.

L'information est écrite dans la cellule mémoire en la basculant d'un état fortement résistif (ou HRS, pour « *High Resistance State* » selon l'acronyme d'origine anglo-saxonne couramment utilisé), appelé également état « OFF », à un état faiblement résistif (ou LRS, pour « *Low Resistance State* »), ou état « ON ». À l'inverse, pour effacer l'information de la cellule mémoire, celle-ci est basculée de l'état faiblement résistif (« OFF ») vers l'état fortement résistif (« ON »).

Le changement de résistance de la cellule mémoire est gouverné par la formation et la rupture d'un filament conducteur de section nanométrique entre les deux électrodes. Ce filament conducteur se créé grâce à la présence de lacunes d'oxygène présentes dans la couche active de la cellule mémoire. En modifiant les potentiels appliqués aux électrodes, il est possible de modifier la répartition du filament, et de modifier ainsi la conduction électrique entre les deux électrodes. Dans la couche active, le filament électriquement conducteur est soit rompu, soit au contraire reformé pour faire varier le niveau de résistance de la cellule mémoire, lors de cycles d'écriture puis de remise à zéro de cette cellule (opérations de SET, lorsque le filament est reformé aboutissant à l'état LRS, et de RESET aboutissant à l'état HRS, lorsque le filament est rompu à nouveau par application respective d'une tension de SET, V_{SET} ou de RESET, V_{RESET} aux bornes des électrodes).

Immédiatement après sa fabrication, la cellule mémoire résistive est dans un état vierge caractérisé par une résistance (dite initiale) très élevée. Cette résistance initiale est bien supérieure à la résistance de la cellule lorsqu'elle est dans l'état fortement résistif. La couche d'oxyde est en effet isolante dans son état initial. Pour que la cellule mémoire puisse être utilisée, il est nécessaire d'accomplir une étape dite de « *forming* ». Cette étape consiste en un claquage partiellement réversible de l'oxyde afin de générer pour la première fois le filament conducteur (et donc de placer la cellule mémoire dans l'état faiblement résistif). Après ce claquage, la couche d'oxyde initialement isolante devient active et la cellule peut commuter entre l'état faiblement résistif et l'état fortement résistif par des opérations d'effacement et d'écriture. L'étape de forming est accomplie en appliquant entre les deux électrodes de la cellule mémoire une tension (dite de « *forming* ») de valeur bien supérieure à la tension nominale de fonctionnement de la cellule mémoire (utilisée lors des cycles d'écriture-effacement suivants), par exemple une tension de l'ordre de 2,5 V pour une tension nominale de l'ordre de 1,5 V.

La tenue en endurance des cellules mémoire OxRAM est une exigence cruciale, notamment pour certaines applications nécessitant une très bonne tenue en endurance, au-delà de 1000 cycles, voire jusqu'à 10000 cycles (on entend par cycle une opération d'écriture/effacement et par tenue en endurance, le fait qu'il soit toujours possible de discriminer un état HRS d'un état LRS au-delà d'un nombre de cycles donné).

### RÉSUMÉ DE L'INVENTION

La présente invention vise donc à améliorer les cellules mémoire résistives de type OxRAM, en améliorant notamment leur tenue en endurance.

L'invention concerne alors un procédé de fabrication d'une cellule mémoire résistive de type OxRAM, comprenant les étapes suivantes :
- formation d'une électrode inférieure en nitrure de titane,
- première implantation d'atomes de silicium dans l'électrode inférieure avec une première dose d'implantation du silicium et une première tension d'accélération d'implantation, ladite première dose d'implantation du silicium étant strictement positive et strictement inférieure à 0,7.10¹⁴ cm⁻²,
- deuxième implantation d'atomes de silicium dans l'électrode inférieure avec une deuxième dose d'implantation du silicium et une deuxième tension d'accélération d'implantation strictement supérieure à la première tension d'accélération d'implantation, ladite deuxième dose d'implantation du silicium étant strictement positive et strictement inférieure à 0,6.10¹⁴ cm⁻²,
   les première et deuxième tensions d'accélération étant choisies pour avoir un profil d'implantation suite à la première et deuxième implantation présentant une concentration maximale de silicium à une profondeur comprise entre 1 et 3 nm à partir de la surface supérieure de l'électrode inférieure,
- dépôt d'une couche active sur l'électrode inférieure implantée,
- dépôt d'une électrode supérieure sur la couche active.

De façon particulièrement surprenante, le dopage par des atomes de Si de l'électrode inférieure en TiN de la cellule OxRAM, permet d'améliorer considérablement la tenue en endurance de la cellule avec certaines conditions d'implantation du Si dans le TiN. Cet effet technique inattendu suppose tout d'abord de réaliser deux implantations, l'une à plus faible tension d'accélération des ions Si visant à implanter le Si à la surface de l'électrode inférieure de la cellule OxRAM et l'autre à plus haute tension d'accélération des ions Si visant à implanter le Si plus en profondeur dans l'électrode inférieure de la cellule OxRAM. Il suppose également d'avoir un profil d'implantation particulier dans l'électrode inférieure avec une concentration maximale de silicium à une profondeur comprise entre 1 et 3 nm à partir de la surface supérieure de l'électrode inférieure. Nous verrons par la suite qu'avec de telles conditions, le taux d'erreur (ou BER pour « *Bit Error Rate* » selon l'acronyme d'origine anglo-saxonne couramment utilisé) sur un ensemble de cellules mémoire obtenues par le procédé selon l'invention diminue avec le nombre de cycles alors qu'il a tendance à augmenter pour d'autres types de cellules et à présenter des valeurs non satisfaisantes pour des applications nécessitant des tenues en endurance importante. Plus le taux d'erreur est faible, mieux les états LRS et HRS sont distingués à l'échelle d'une matrice de cellules mémoire.

Par définition, ce taux d'erreur correspond au pourcentage de cellules mémoire de l'ensemble de cellules mémoire considérées qui ne vont pas présenter de propriétés satisfaisantes.

On notera que l'ordre des première et deuxième implantations peut être inversé de sorte qu'il est possible de réaliser la première implantation avant la deuxième ou inversement la deuxième avant la première. De préférence, la première implantation est cependant réalisée avant la deuxième implantation.

Outre les caractéristiques qui viennent d'être évoquées dans les paragraphes précédents, le procédé de fabrication selon l'invention peut présenter une ou plusieurs caractéristiques complémentaires parmi les suivantes, considérées individuellement ou selon toutes les combinaisons techniquement possibles :
- les première et deuxième tensions d'accélération sont choisies pour avoir un profil d'implantation suite à la première et deuxième implantation présentant une concentration maximale de silicium à une profondeur comprise entre 1 et 1,6 nm à partir de la surface supérieure de l'électrode inférieure et une largeur du profil d'implantation à la moitié de la valeur de la concentration maximale d'implantation de silicium comprise entre 1,6 nm et 2 nm.
- les première et deuxième tensions d'accélération sont choisies pour avoir un profil d'implantation suite à la première et deuxième implantation présentant une concentration maximale de silicium à une profondeur comprise entre 1,1 et 1,5 nm à partir de la surface supérieure de l'électrode inférieure et une largeur du profil d'implantation à la moitié de la valeur de la concentration maximale d'implantation de silicium comprise entre 1,7 nm et 1,9 nm.
- le dépôt de l'électrode supérieure sur la couche active comprend :
   - Le dépôt d'une première couche conductrice, en contact avec la couche active et étant choisie pour créer des lacunes d'oxygène dans la couche active, et
   - Le dépôt d'une deuxième couche conductrice disposée sur la première couche conductrice.
- Le matériau de la première couche conductrice est du titane et le matériau conducteur de la deuxième couche conductrice est du nitrure de titane.
- la première tension d'accélération est comprise entre 0,3 kV et 0,7 kV et la deuxième tension d'accélération est comprise entre 1 kV et 2kV.
- la première tension d'accélération est égale à 0,5 kV et la deuxième tension d'accélération est égale à 1,5 kV.
- la première dose d'implantation du silicium est égale à 0,5.10¹⁴ cm⁻² et la deuxième dose d'implantation du silicium est égale à 0,3.10¹⁴ cm⁻².
- le dépôt de la couche active sur l'électrode inférieure implantée comporte les étapes suivantes :
   - dépôt d'une couche de matériau actif sur l'électrode inférieure implantée,
   - dépôt d'une couche d'oxyde diélectrique sur la couche de matériau actif,
   - implantation d'atomes de silicium à-travers la couche d'oxyde diélectrique, la dose d'implantation et la tension d'accélération d'implantation étant choisies de sorte à ce que les atomes de silicium soient implantés au moins en partie dans la couche de matériau actif.
- le matériau actif est à base de dioxyde d'hafnium.
- l'oxyde diélectrique est à base d'oxyde d'aluminium.
- l'étape d'implantation de silicium à-travers la couche d'oxyde diélectrique est mise en oeuvre à une tension d'accélération d'implantation comprise entre 1,5 et 3,5 kilovolts, et de préférence égale à 2,5 kV, et une dose d'implantation du silicium comprise entre 10¹⁵ cm⁻² et 5.10¹⁵ cm⁻², et de préférence égale à 2.10¹⁵ cm⁻².
- le matériau de la première couche conductrice est du titane et le matériau conducteur de la deuxième couche conductrice est du nitrure de titane.
- l'épaisseur de l'électrode inférieure en nitrure de titane est choisie entre 10 et 200 nm.

L'invention concerne également une cellule mémoire résistive de type OxRAM susceptible d'être obtenu par le procédé selon l'invention.

A ce stade, il n'est pas possible de caractériser structurellement la cellule mémoire résistive de type OxRAM selon l'invention autrement que par son procédé d'obtention. Toutefois, le procédé de fabrication selon l'invention confère à la cellule mémoire de type OxRAM selon l'invention des propriétés en endurance particulièrement avantageuses comparées à celles des cellules résistives de types OxRAM de l'état de l'art.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
La [Fig. 1] représente, sous forme d'un logigramme, les différentes étapes du procédé selon l'invention,
Les [Fig. 2], [Fig. 3], [Fig. 4], [Fig. 5], [Fig. 6], [Fig. 7] et [Fig. 8], représentent les différentes étapes du procédé de la [Fig. 1],
La [Fig. 9] représente les différents profils d'implantation dans l'électrode inférieure de la cellule mémoire de type OxRAM selon l'invention,
La [Fig. 10] représente le taux d'erreur BER en fonction du nombre de cycles pour différentes catégories de cellules mémoire de type OxRAM dont les cellules mémoire selon l'invention.
Les [Fig. 11] et [Fig. 12] représentent l'évolution de la fraction de cellules mémoire nécessitant une ou plusieurs répétitions de programmation, en set et en reset, en fonction du nombre de cycles.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

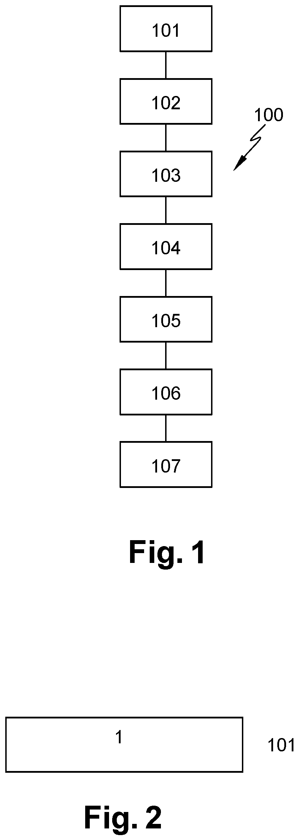

La figure 1 représente le logigramme illustrant les différentes étapes du procédé 100 de fabrication d'une cellule mémoire OxRAM selon l'invention.

Comme le montre la figure 2, le procédé 100 débute par une étape 101 de formation d'une première électrode 1 formée par une couche en nitrure de titane correspondant à l'électrode inférieure 1 de la cellule mémoire OxRAM. Cette étape vise donc à former l'électrode inférieure 1, par exemple sur un substrat (substrat non représenté sur les figures). L'électrode inférieure 1 présente par exemple une épaisseur comprise entre 10 et 200 nm, ici 60 nm.

En pratique, l'électrode inférieure 1 est par exemple formée par pulvérisation cathodique réactive dans une chambre de dépôt sous vide.

En variante, l'électrode inférieure 1 peut être formée par un dépôt chimique en phase vapeur ou selon une structure en damascène.

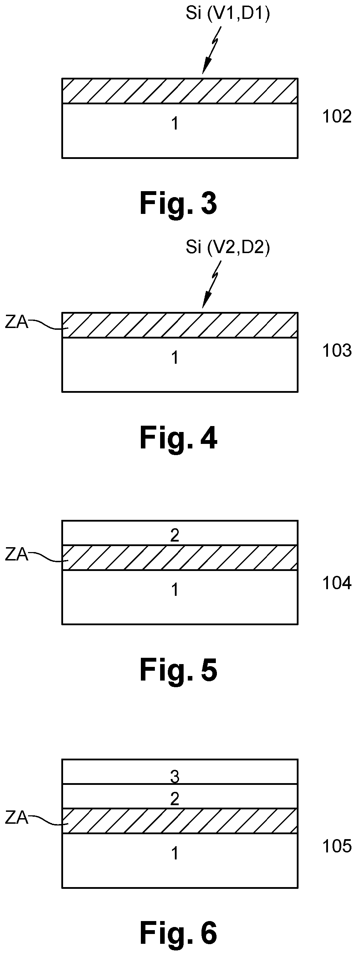

Le procédé 100 se poursuit par une étape 102 (figure 3) correspondant à une première implantation d'atomes de silicium Si dans l'électrode inférieure 1.

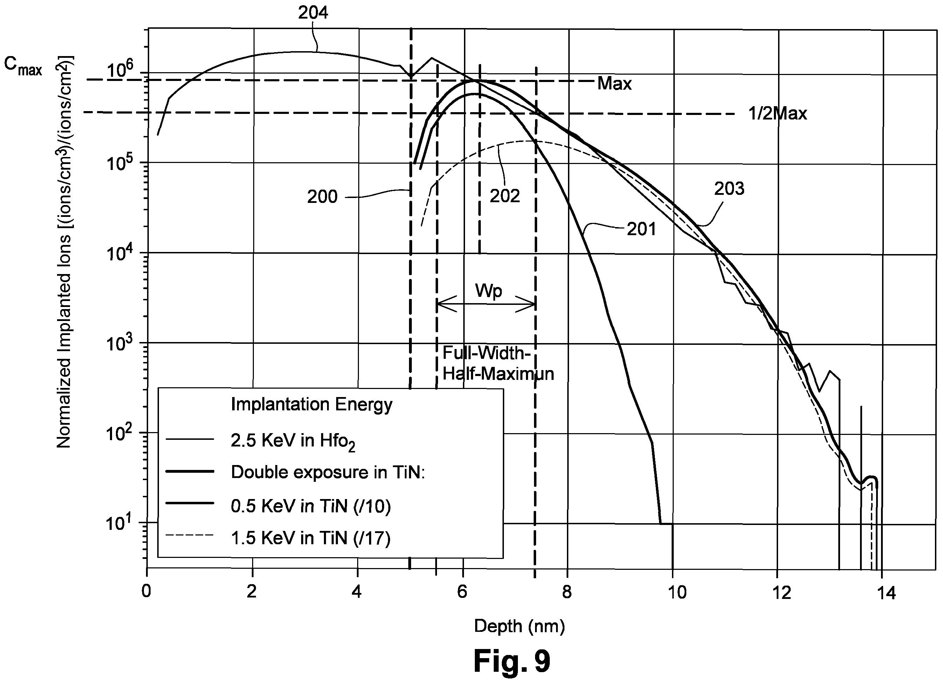

Selon cette première implantation, le Si est implanté, dans la couche de TiN de l'électrode inférieure 1, selon un profil déterminé 201 représenté en figure 9. La dose d'implantation D1 et la tension d'accélération d'implantation V1 sont choisies pour obtenir une implantation à la surface de l'électrode inférieure 1. La dose D1 d'implantation du silicium est strictement positive et strictement inférieure à 0,7.10¹⁴ cm⁻²; selon un mode de réalisation préférentiel, la dose D1 est égale à 0,5.10¹⁴ cm⁻². La tension d'accélération V1 des ions Si est comprise entre 0,3 kV et 0,7 kV ; selon un mode de réalisation préférentiel, la tension d'accélération est égale à 0,5 kV.

La figure 9 montre notamment les différents profils d'implantation dans la couche de TiN correspondant à l'électrode inférieure 1 dont la surface supérieure est délimitée par les pointillés 200 : la première implantation à la dose D1 et à la tension V1 est représentée par le profil 201 présentant une concentration maximale de Si à une profondeur 1,2 nm à partir de la surface supérieure de l'électrode inférieure et une largeur du profil d'implantation 201 à la moitié de la valeur de la concentration maximale d'implantation de silicium égale à 1,5 nm. Les profils d'implantation représentent une valeur représentative des ions implantés de façon normalisée (ratio de la concentration volumique d'ions implantés sur la dose d'ions implantés) en fonction de la profondeur dans les couches implantées.

Le procédé 100 se poursuit par une étape 103 (figure 4) correspondant à une deuxième implantation d'atomes de silicium Si dans l'électrode inférieure 1.

Selon cette deuxième implantation, le Si est implanté, dans la couche de TiN de l'électrode inférieure 1, selon un profil déterminé 202 représenté en figure 9 présentant une concentration maximale de Si à une profondeur 2,2 nm à partir de la surface supérieure de l'électrode inférieure et une largeur du profil d'implantation à la moitié de la valeur de la concentration maximale d'implantation de silicium égale à 3,0 nm. La dose d'implantation D2 et la tension d'accélération d'implantation V2 de cette seconde implantation sont choisies pour obtenir une implantation plus en profondeur de l'électrode inférieure 1. La dose D2 d'implantation du silicium est strictement positive et strictement inférieure à 0,6.10¹⁴ cm-²; selon un mode de réalisation préférentiel, la dose D2 est égale à 0,3.10¹⁴ cm⁻². La tension d'accélération V2 des ions Si est comprise entre 1 kV et 2 kV ; selon un mode de réalisation préférentiel, la tension d'accélération est égale à 1,5 kV.

A l'issue des étapes 102 et 103, le profil global résultant des première et deuxième implantations est illustré par la référence 203 présentant une concentration maximale de silicium Cmax à une profondeur comprise entre 1 et 3 nm à partir de la surface supérieure de l'électrode inférieure (et préférentiellement comprise entre 1 et 1,6 nm, et encore préférentiellement entre 1,1 et 1,5 nm, et ici égale à 1,3 nm) et une largeur Wp du profil d'implantation à la moitié de la valeur de la concentration maximale d'implantation de silicium comprise entre 1,6 nm et 2 nm (et préférentiellement comprise entre 1,7 et 1,9 nm, et ici égale à 1,86 nm). La zone implantée par les première et deux implantations de l'électrode inférieure 1 est illustrée par la référence ZA en figure 4.

Puis, le procédé se poursuit par une étape 104 (figure 5) de dépôt d'une couche de matériau actif 2. Cette couche de matériau actif 2 est formée sur l'électrode inférieure 1. Le dépôt de la couche de matériau actif 2 est réalisé de telle manière que cette couche présente une épaisseur sensiblement constante en tout point. Dans cette description, on entend par « sensiblement constante », une épaisseur ne variant pas de plus de 20 %, de préférence de plus de 10 %, et de préférence encore de plus de 5%. De préférence ici, la couche de matériau actif 2 est à base du dioxyde d'hafnium HfO₂ amorphe. Dans la présente description, on entend par l'expression « à base de » que la couche concernée comprend plus de 50% de l'élément mentionné après cette expression (par exemple ici, cela signifie que la couche de matériau actif 2 comprend plus de 50% de dioxyde d'hafnium). La couche de matériau actif 2 présente ici une épaisseur comprise entre 3 et 10 nm, par exemple ici 5 nm.

En pratique, la couche de matériau actif 2 est déposée par une méthode de dépôt par couche atomique (ou ALD pour « *Atomic Layer Deposition* » selon l'acronyme d'origine anglo-saxonne couramment utilisé).

En variante, la couche de matériau actif peut être déposée par pulvérisation cathodique. En variante encore, la couche de matériau actif peut être déposée par une méthode de dépôt physique en phase vapeur (ou PVD pour « *Physical Vapor Deposition* »). En variante encore, la couche de matériau actif peut être déposée par une méthode de dépôt par faisceau d'ions (ou IBD pour « *Ion* Beam *Deposition* »)*.*

Comme cela est représenté sur la figure 6, de façon optionnelle, le procédé 100 se poursuit par l'étape 105 de dépôt d'une couche d'oxyde diélectrique 3. Cette couche d'oxyde diélectrique 3 est formée sur la couche de matériau actif 2. La couche d'oxyde diélectrique 3 comprend par exemple un oxyde métallique ou un oxyde semiconducteur. De préférence, il s'agit d'un oxyde d'aluminium Al₂O₃. En variante, il peut également s'agir de dioxyde de silicium SiO₂.

La couche d'oxyde diélectrique 3 présente ici une épaisseur comprise entre 0,3 et 1,5 nm, par exemple ici 0,5 nm.

En pratique, la couche d'oxyde diélectrique 3 est déposée par une méthode de dépôt par couche atomique (ou ALD). En variante, la couche d'oxyde diélectrique 3 peut être déposée par pulvérisation cathodique. En variante encore, la couche d'oxyde diélectrique peut être déposée par une méthode de dépôt physique en phase vapeur (ou PVD pour « *Physical Vapor Deposition* »). En variante encore, la couche d'oxyde diélectrique peut être déposée par une méthode de dépôt par faisceau d'ions (ou IBD).

Cette couche d'oxyde diélectrique 3 déposée sur la couche comprenant le matériau actif est positionnée entre la couche comprenant le matériau actif et la couche formant l'électrode supérieure. Cette couche agit alors comme une barrière de diffusion des lacunes d'oxygène (par rapport au filament) et améliore alors les propriétés de commutation de la cellule mémoire. En particulier, cette configuration permet d'améliorer la mise en oeuvre des cycles d'écriture et d'effacement. Comme indiqué précédemment, il est possible de s'affranchir de cette étape 105 de dépôt de la couche d'oxyde diélectrique et de passer directement de l'étape 104 de dépôt de la couche de matériau actif à l'étape 106 d'implantation de silicium dans la couche de matériau actif.

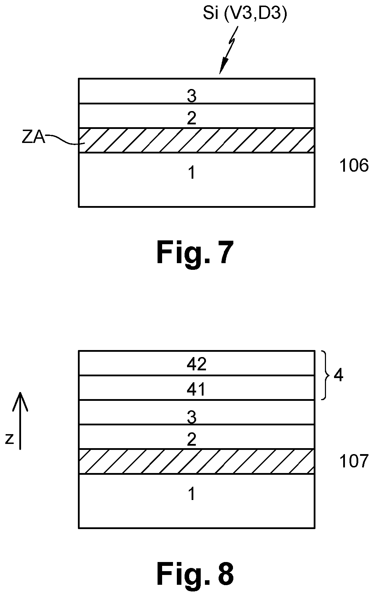

Comme illustré en figure 7, le procédé 100 se poursuit par une étape 106 d'implantation de silicium dans la couche active formée par la couche d'oxyde diélectrique 3 en Al₂O3 et la couche de matériau actif 2 en HfO₂ formées aux étapes 104 et 105. Le silicium est implanté selon un profil déterminé illustré par la référence 204 en figure 9. Ainsi, selon que le dépôt 105 de la couche d'oxyde diélectrique a lieu ou non, la couche dite active comporte soit seulement la couche de matériau actif 2 soit l'empilement de la couche de matériau actif et de la couche d'oxyde diélectrique 3.

De manière avantageuse, l'étape 106 d'implantation est mise en oeuvre à une tension d'accélération d'implantation V3 comprise entre 1,5 et 3,5 kV, ici égale à 2,5 kV, pour une dose d'implantation D3 de l'ordre de 2.10¹⁵ cm⁻².

Comme le montre la figure 9, le profil d'implantation 204 s'étend jusque dans la zone ZA déjà implantée de l'électrode inférieure 1.

Le procédé se poursuit enfin par une étape 107 de dépôt d'une deuxième électrode 4 formant l'électrode supérieure (figure 8). L'électrode supérieure 4 est formée sur la couche active formée comme indiqué précédemment de la couche de matériau actif 2 et de la couche d'oxyde diélectrique 3. Plus particulièrement, l'électrode supérieure 4 est déposée sur la couche d'oxyde diélectrique 3.

L'électrode supérieure 4 comprend une première couche conductrice 41, par exemple en titane Ti et une deuxième couche conductrice 42, par exemple en nitrure de titane TiN. L'étape de dépôt de l'électrode supérieure 4 comprend donc ici deux sous-étapes : une première sous-étape de dépôt de la première couche conductrice 41 et une deuxième sous-étape de dépôt de la deuxième couche conductrice 42.

La première couche conductrice 41 est donc tout d'abord déposée sur la couche d'oxyde diélectrique 3. La première couche conductrice 41 est par exemple formée par pulvérisation cathodique dans une chambre de dépôt sous vide.

La première couche conductrice 41 en Ti présente la particularité d'être une couche adaptée pour créer des lacunes d'oxygène dans la couche active lorsque cette première couche conductrice 41 est en contact avec la couche active. Selon l'appellation d'origine anglo-saxonne couramment utilisée, la première couche conductrice 41 est une couche de type « *Oxygen scavenging layer*». Comme le mécanisme de formation du filament conducteur dans la couche d'oxyde diélectrique 3 implique généralement une réorganisation des lacunes en oxygène au sein de l'oxyde diélectrique, la première couche conductrice 41 permet de faciliter les échanges d'oxygène avec la couche active. On notera que cette première couche conductrice 41 permet de créer des lacunes d'oxygène dans la couche de matériau actif 2 même lorsque cette première couche conductrice est déposée sur la couche d'oxyde diélectrique 3. En d'autres termes, la première couche conductrice 41 crée des lacunes d'oxygène dans la couche de matériau actif 2 avec ou sans dépôt de la couche d'oxyde diélectrique 3.

Puis, la deuxième couche conductrice 42 est déposée sur la première couche conductrice 41 formée. La deuxième couche conductrice 42 est par exemple formée par pulvérisation cathodique réactive dans une chambre de dépôt sous vide.

La première couche conductrice 41 présente une épaisseur comprise entre 3 et 20 nanomètres, ici 5 nm. La deuxième couche conductrice 42 a une épaisseur comprise entre 10 et 200 nanomètres, ici 150 nm.

A l'issue de cette étape 107, la cellule mémoire 5 de type OxRAM est obtenue et se présente sous la forme d'un empilement de couches qui s'étend selon un axe z. L'électrode inférieure 1, la couche de matériau actif 2, la couche d'oxyde diélectrique 3 et l'électrode supérieure 4 forment les différentes couches de cet empilement. Les différentes couches s'étendent parallèlement les unes aux autres (et parallèlement à un substrat, non représenté, sur lequel repose la cellule mémoire 5). L'axe z est ici perpendiculaire au plan des différentes couches de l'empilement formant la cellule mémoire 5.

Nous allons à présent montrer les avantages (notamment les meilleures performances en endurance) de la cellule mémoire de type OxRAM telle que représentée en figure 8.

Pour ce faire, nous utiliserons un indicateur, le taux d'erreur (ou BER pour « *Bit Error Rate* » selon l'acronyme d'origine anglo-saxonne couramment utilisé) évalué sur un ensemble de cellules mémoire (ici 16000 cellules environ). Par définition, ce taux d'erreur correspond au pourcentage de cellules mémoire de l'ensemble de cellules mémoire considérées qui ne vont pas présenter de propriétés satisfaisantes.

En pratique, ce taux d'erreur est évalué en représentant les distributions des cellules mémoire de l'ensemble considéré en fonction de la résistance R (en Ohm Ω) pour les états LRS et HRS. Les distributions des cellules mémoire sont ici considérées de manière cumulative (il s'agit de fonction de distribution cumulative ou CDF pour « *Cumulative Distribution Function* » selon l'acronyme d'origine anglo-saxonne couramment utilisé). Le taux d'erreur correspond alors au point d'intersection des distributions représentant les états LRS et HRS.

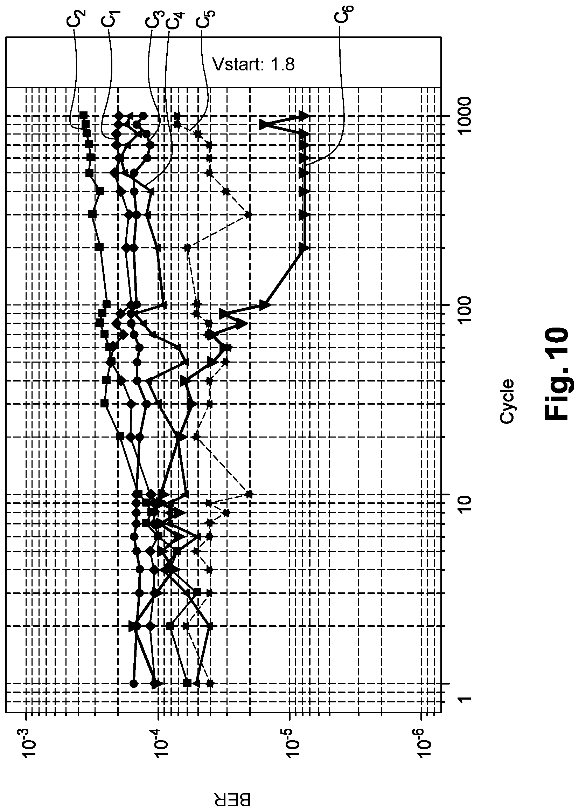

La figure 10 représente le taux d'erreur BER pour 6 types de cellules mémoires C1 à C6 en fonction du nombre de cycles effectué sur ces cellules, un cycle correspondant à une étape de set et de reset. Les cellules de type C6 sont les cellules mémoire de type OxRAM selon l'invention et telles qu'obtenues à l'issue du procédé 100 illustré aux figure 1 à 8. Les autres cellules C1 à C5 présentent un empilement de couches identiques aux cellules de type C6 et diffèrent de ces dernières uniquement au niveau du dopage de l'électrode inférieure. Rappelons les caractéristiques d'implantation de l'électrode inférieure des cellules C6 selon l'invention :
- Première implantation à une tension d'accélération de 0,5 kV et une dose d'implantation de 0,5.10¹⁴cm⁻².
- Deuxième implantation à une tension d'accélération de 1,5 kV et une dose d'implantation de 0,3.10¹⁴cm⁻².

Les cellules de type C1 ont une électrode inférieure ayant subi une seule implantation avec une faible tension d'accélération (ici 0,5 kV) et une dose d'implantation de 1.10¹⁴cm⁻².

Les cellules de type C2 ont une électrode inférieure ayant subi une double implantation :
- Première implantation à une tension d'accélération de 0,5 kV et une dose d'implantation de 1.10¹⁴cm⁻².
- Deuxième implantation à une tension d'accélération de 1,5 kV et une dose d'implantation de 0,6.10¹⁴cm⁻².

Les cellules de type C3 ont une électrode inférieure ayant subi une double implantation :
- Première implantation à une tension d'accélération de 0,5 kV et une dose d'implantation de 1.10¹⁴cm⁻².
- Deuxième implantation à une tension d'accélération de 4 kV et une dose d'implantation de 7.10¹⁴cm⁻².

Les cellules de type C4 ont une électrode inférieure ayant subi une double implantation :
- Première implantation à une tension d'accélération de 0,5 kV et une dose d'implantation de 2.10¹⁴cm⁻².
- Deuxième implantation à une tension d'accélération de 1,5 kV et une dose d'implantation de 1,2.10¹⁴cm⁻².

Les cellules de type C5 ont une électrode inférieure n'ayant subi aucune implantation.

Comme illustré sur la figure 10, à part les cellules de type C6 selon l'invention, le taux d'erreur de l'ensemble des types de cellules C1 à C5 se dégrade avec le nombre de cycles. A l'inverse, les cellules mémoire selon l'invention présente un taux d'erreur qui diminue progressivement avec le nombre de cycles jusqu'à se stabiliser à partir d'une centaine de cycles. Le taux d'erreur des cellules mémoire selon l'invention reste globalement stable même après 10000 cycles alors qu'il se dégrade, en ce y-compris pour les cellules de type C5 présentant une électrode inférieure non implantée.

De façon surprenante, on constate que la simple implantation en Si de l'électrode inférieure ne suffit pas à améliorer les performances en endurance d'une cellule mémoire de type OxRAM puisque les cellules de type C1 à C4 présentent également une implantation de l'électrode inférieure et présentent des performances en endurance dégradées. Il convient donc que les conditions particulières d'implantation du procédé selon l'invention soient réalisées pour obtenir les performances en endurance de la cellule mémoire selon l'invention dont les caractéristiques intrinsèques ne peuvent être définies à ce stade autrement que par son procédé de fabrication. On constate par ailleurs que le taux d'erreur des cellules mémoire de type OxRAM selon l'invention commence par diminuer avec le nombre de cyclage. Il peut donc s'avérer intéressant de procéder à une étape préalable (après sa fabrication et avant l'utilisation) consistant à faire cycler la cellule mémoire selon l'invention sur un nombre N de cycles (avec N entier supérieur ou égal à 100) de manière à obtenir un plus faible taux d'erreur qui se stabilise ensuite.

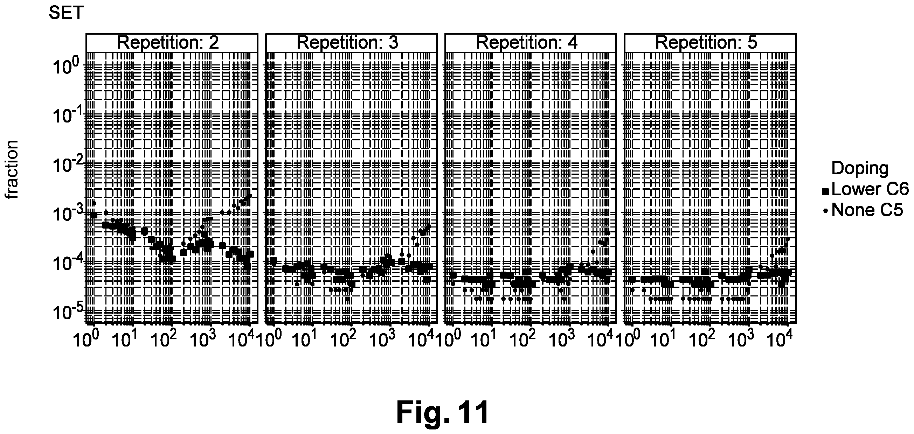

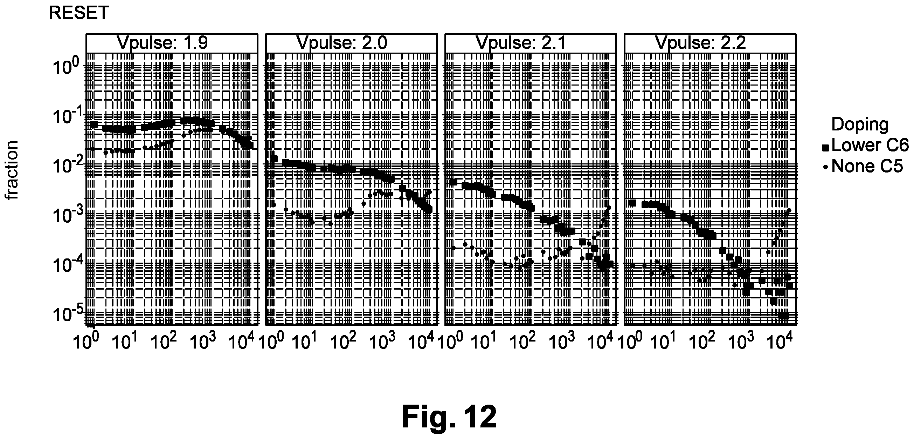

Les figures 11 et 12 illustrent un autre avantage des cellules mémoire de type OxRAM selon l'invention. Ces figures reposent sur le mécanisme dit « de programmation intelligente ». Cette méthode consiste à vérifier, après chaque opération, que la cellule mémoire présente bien le niveau de résistance correspondant à l'état dans lequel elle a été programmée (set ou reset). Si tel n'est pas le cas, l'opération de programmation (set ou reset) est réitérée autant de fois que nécessaire et jusqu'à obtention d'un niveau de résistance conforme aux attentes : le nombre nécessaire d'itération est appelé répétition. De façon plus précise, sur la figure 11 (set), la répétition consiste à répéter la même impulsion de set. Sur la figure 12 (reset), la répétition consiste à augmenter la tension d'impulsion à chaque répétition.

Ainsi, la figure 11 montre la fraction de cellules mémoire selon l'invention C6 et de cellules mémoire sans implantation de l'électrode inférieure C5 qu'il a été nécessaire de reprogrammer avec un nombre de répétition donné (allant de 2 à 5) pour les opérations de set en fonction du nombre de cycles. A titre d'exemple, on voit que dans le cas où deux répétitions sont nécessaires, on a environ une cellule sur 10000 de type C5 ou C6 qui a été réécrite deux fois au 100^{ième} cycle. La figure 12 montre la fraction de cellules mémoire selon l'invention C6 et de cellules mémoire sans implantation de l'électrode inférieure C5 qu'il a été nécessaire de reprogrammer avec un nombre de répétition donné (allant de 2 à 5) pour les opérations de reset en fonction du nombre de cycles.

Dans le cas d'opérations de reset (figure 12), on observe que plus on réalise d'opérations de cyclage avec les cellules mémoire C6 selon l'invention moins on a besoin de rajouter d'impulsions de reprogrammation. A l'inverse, les cellules mémoire de type C5 avec une électrode inférieure non dopée nécessite davantage de répétitions au-delà d'une centaines de cycles. Ce premier résultat confirme la très bonne tenue en endurance des cellules mémoire selon l'invention. En effet, le fait de moins « stresser » les cellules mémoire du fait du moindre nombre de répétitions nécessaires, entraîne une meilleure endurance des cellules mémoire.

Dans le cas d'opérations de set (figure 11), on observe une certaine stabilité, confirmant là-encore les performances en endurance des cellules mémoire selon l'invention.

## Revendications

1. Procédé de fabrication d'une cellule mémoire résistive de type OxRAM, comprenant les étapes suivantes :
- formation d'une électrode inférieure en nitrure de titane,
- première implantation d'atomes de silicium dans l'électrode inférieure avec une première dose d'implantation du silicium et une première tension d'accélération d'implantation, ladite première dose d'implantation du silicium étant strictement positive et strictement inférieure à 0,7.10¹⁴ cm⁻²,
- deuxième implantation d'atomes de silicium dans l'électrode inférieure avec une deuxième dose d'implantation du silicium et une deuxième tension d'accélération d'implantation strictement supérieure à la première tension d'accélération d'implantation, ladite deuxième dose d'implantation du silicium étant strictement positive et strictement inférieure à 0,6.10¹⁴ cm⁻²,
les première et deuxième tensions d'accélération étant choisies pour avoir un profil d'implantation suite à la première et deuxième implantation présentant une concentration maximale de silicium à une profondeur comprise entre 1 et 3 nm à partir de la surface supérieure de l'électrode inférieure,
- dépôt d'une couche active sur l'électrode inférieure implantée,
- dépôt d'une électrode supérieure sur la couche active.

2. Procédé selon la revendication 1 dans lequel les première et deuxième tensions d'accélération sont choisies pour avoir un profil d'implantation suite à la première et deuxième implantation présentant une concentration maximale de silicium à une profondeur comprise entre 1 et 1,6 nm à partir de la surface supérieure de l'électrode inférieure et une largeur du profil d'implantation à la moitié de la valeur de la concentration maximale d'implantation de silicium comprise entre 1,6 nm et 2 nm.

3. Procédé selon la revendication 2 dans lequel les première et deuxième tensions d'accélération sont choisies pour avoir un profil d'implantation suite à la première et deuxième implantation présentant une concentration maximale de silicium à une profondeur comprise entre 1,1 et 1,5 nm à partir de la surface supérieure de l'électrode inférieure et une largeur du profil d'implantation à la moitié de la valeur de la concentration maximale d'implantation de silicium comprise entre 1,7 nm et 1,9 nm.

4. Procédé selon l'une des revendications précédentes **caractérisé en ce que** le dépôt de l'électrode supérieure sur la couche active comprend :
- Le dépôt d'une première couche conductrice, en contact avec la couche active et étant choisie pour créer des lacunes d'oxygène dans la couche active, et
- Le dépôt d'une deuxième couche conductrice disposée sur la première couche conductrice.

5. Procédé selon la revendication précédente, dans laquelle le matériau de la première couche conductrice est du titane et le matériau conducteur de la deuxième couche conductrice est du nitrure de titane.

6. Procédé selon l'une des revendications précédentes dans lequel la première tension d'accélération est comprise entre 0,3 kV et 0,7 kV et la deuxième tension d'accélération est comprise entre 1 kV et 2kV.

7. Procédé selon l'une des revendications précédentes dans lequel la première tension d'accélération est égale à 0,5 kV et la deuxième tension d'accélération est égale à 1,5 kV.

8. Procédé selon l'une des revendications précédentes dans lequel la première dose d'implantation du silicium est égale à 0,5.10¹⁴ cm⁻² et la deuxième dose d'implantation du silicium est égale à 0,3.10¹⁴cm⁻²

9. Procédé selon l'une des revendications précédentes dans lequel le dépôt de la couche active sur l'électrode inférieure implantée comporte les étapes suivantes :
- dépôt d'une couche de matériau actif sur l'électrode inférieure implantée,
- dépôt d'une couche d'oxyde diélectrique sur la couche de matériau actif,
- implantation d'atomes de silicium à-travers la couche d'oxyde diélectrique, la dose d'implantation et la tension d'accélération d'implantation étant choisies de sorte à ce que les atomes de silicium soient implantés au moins en partie dans la couche de matériau actif.

10. Procédé selon la revendication précédente dans lequel le matériau actif est à base de dioxyde d'hafnium.

11. Procédé selon la revendication 9 ou 10 dans lequel l'oxyde diélectrique est à base d'oxyde d'aluminium.

12. Procédé selon l'une des revendications 6 à 8, dans lequel l'étape d'implantation de silicium à-travers la couche d'oxyde diélectrique est mise en oeuvre à une tension d'accélération d'implantation comprise entre 1,5 et 3,5 kilovolts, et de préférence égale à 2,5 kV, et une dose d'implantation du silicium comprise entre 10¹⁵ cm⁻² et 5.10¹⁵ cm⁻², et de préférence égale à 2.10¹⁵ cm⁻².

13. Procédé selon l'une des revendications précédentes **caractérisé en ce que** l'épaisseur de l'électrode inférieure en nitrure de titane est choisie entre 10 et 200 nm.

14. Cellule mémoire de type OxRAM obtenu par le procédé selon l'une quelconque des revendications 1 à 13.
